(19) Europäisches Patentamt
European Patent Office
Office européen des brevets

(11) **EP 3 132 271 B1**

(12) **EUROPÄISCHE PATENTSCHRIFT**

(45) Veröffentlichungstag und Bekanntmachung des Hinweises auf die Patenterteilung:
**04.07.2018 Patentblatt 2018/27**

(21) Anmeldenummer: **15713698.7**

(22) Anmeldetag: **26.03.2015**

(51) Int Cl.:
**G01R 31/00** *(2006.01)*  **B60R 21/017** *(2006.01)*

(86) Internationale Anmeldenummer:
**PCT/EP2015/056605**

(87) Internationale Veröffentlichungsnummer:
**WO 2015/158521 (22.10.2015 Gazette 2015/42)**

(54) **VERFAHREN UND VORRICHTUNG ZUM ERMITTELN EINES INNENWIDERSTANDES EINES VERSORGUNGSNETZES ZUR ENERGIEVERSORGUNG EINER PERSONENSCHUTZEINRICHTUNG EINES FAHRZEUGS**

METHOD AND DEVICE FOR ASCERTAINING AN INNER RESISTANCE OF A SUPPLY NETWORK FOR SUPPLYING ENERGY TO A PERSONAL PROTECTION DEVICE OF A VEHICLE

PROCÉDÉ ET DISPOSITIF DE DÉTERMINATION DE LA RÉSISTANCE INTERNE D'UN RÉSEAU D'ALIMENTATION FOURNISSANT DE L'ÉNERGIE À UN ÉQUIPEMENT DE PROTECTION DES PERSONNES DANS UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.04.2014 DE 102014207171**

(43) Veröffentlichungstag der Anmeldung:
**22.02.2017 Patentblatt 2017/08**

(73) Patentinhaber: **Robert Bosch GmbH**
**70442 Stuttgart (DE)**

(72) Erfinder:
• **SCHUMACHER, Hartmut**
**71691 Freiberg (DE)**
• **LIST, Carsten**
**74399 Walheim (DE)**

(56) Entgegenhaltungen:
**CN-A- 101 477 149**   **US-A- 6 114 838**
**US-A1- 2005 231 218**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Stand der Technik

Die vorliegende Erfindung bezieht sich auf ein Verfahren zum Ermitteln eines Innenwiderstandes eines Versorgungsnetzes zur Energieversorgung einer Personenschutzeinrichtung eines Fahrzeugs, auf ein entsprechendes Steuergerät bzw. eine entsprechende Vorrichtung sowie auf ein entsprechendes Computerprogrammprodukt.

Für die sichere Versorgung eines Airbag-Steuergerätes wird eine höchst zuverlässige Masse-Anbindung am Fahrzeugchassis verwendet. Auf Steuergeräteseite wird in der Regel die bereitgestellte Chassis-Masse über redundante elektrische Verbindungen (z. B. Schraubverbindungen, Einpressverbindungen) mit der Leiterplatte verbunden. Auch die Variante der Masseanbindung über das Airbag-Anschlusskabel durch eine oder mehrere Steckverbindungen in Kombination mit einem Einpress- oder Lötanschluss zur Leiterplatte ist in Anwendung.

Die Versorgungsplusleitung (KL15R, KL15, UBAT ... etc.) wird in der Regel singulär oder redundant über das Airbag-Anschlusskabel durch eine oder mehrere Steckverbindungen in Kombination mit einem Einpress- oder Lötanschluss zur Leiterplatte bereitgestellt. Über die elektrischen Eigenschaften der Airbag-Versorgungsanbindung gibt es bei ausreichend hoher Steuergeräte-Versorgungsspannung keine sichere Eigendiagnose. Insbesondere fehlt die Information, wie sich die Versorgungsspannung verhält, wenn mehr Leistung vom Steuergerät benötigt wird. Intakte Versorgungsanschlüsse garantieren normalerweise Versorgungsinnenwiderstände von $(100...400)\ m\Omega$. Diese werden wesentlich durch die Kupferwiderstände der Versorgungsleitungen und Kontaktwiderstände bestimmt. Der Anteil der durch Innenwiderstände der Fahrzeugbatterie bzw. des Generators (Generator-Regler) verursacht wird ist Sehr gering (ca. 10%).

Heute beschränkt sich die Fehlererkennung im Airbag Versorgungsnetz auf drastische Fehler, wie Generator-Reglerdefekt, Batteriedefekt und Versorgungsleitung unterbrochen. Dies geschieht durch ständige Überwachung der Versorgungsspannung mit Fehlererkennung bei Unter- und Überspannung, sowie auf Maßnahmen im Service die eine Kontrolle von Masseverbindungen an das Fahrzeugchassis vorsehen. US 2005/231218 A1 offenbart eine Überprüfung und eine Ermittlung eines Innenwiderstandes einer Personenschutzeinrichtung in einem Fahrzeug.

US 6114 838 A und CN 101 477 149 A offenbaren die Ermittlung eines Innenwiderstandes einer Batterie.

Offenbarung der Erfindung

Vor diesem Hintergrund wird mit dem hier vorgestellten Ansatz ein Verfahren zum Ermitteln eines Innenwiderstandes eines Versorgungsnetzes einer Personenschutzeinrichtung eines Fahrzeugs, weiterhin eine Vorrichtung oder ein Steuergerät, die/das dieses Verfahren verwendet sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Es wird ein Verfahren zum Ermitteln eines Innenwiderstandes eines Versorgungsnetzes zur Energieversorgung einer Personenschutzeinrichtung eines Fahrzeugs vorgestellt, wobei die Personenschutzeinrichtung eine Ladeeinheit beinhaltet, die mittels einer Primärschnittstelle mit dem Versorgungsnetz und mittels einer Sekundärschnittstelle mit einem Energiezwischenspeicher zur Zwischenspeicherung von Energie für Aktivierungen von Personenschutzmitteln der Personenschutzeinrichtung und der Versorgung der Personenschutzeinrichtung nach Trennung von dem Versorgungsnetz verbunden ist, wobei das Verfahren die folgenden Schritte aufweist:

- Einprägen eines ersten Ladestromwertes an der Sekundärschnittstelle;
- Erfassen eines ersten Stromes und/oder einer ersten Spannung an der Primärschnittstelle während des Einprägens;
- Aufprägen eines von dem ersten Ladestromwert unterschiedlichen zweiten Ladestromwertes an der Sekundärschnittstelle;
- Bestimmen eines zweiten Stromes und/oder einer zweiten Spannung an der Primärschnittstelle während des Aufprägens; und
- Ermitteln des Innenwiderstandes des Versorgungsnetzes unter Verwendung des ersten Stromes und des zweiten Stromes und/oder der ersten Spannung und der zweiten Spannung.

Unter einem Innenwiderstand des Versorgungsnetzes der Personenschutzeinrichtung kann ein Widerstand verstanden werden, der sich aus mehreren Teilwiderständen zusammensetzt. Diese Teilwiderstände werden durch den Generator und oder Batterie den Kontaktwiderständen aller verwendeten Kontaktiereinheiten im Versorgungskreis und den Transportwiderständen (Cu-Leitungen; Fahrzeugchassis) im Versorgungskreis gebildet.

Unter einem Versorgungsnetz der Personenschutzeinrichtung kann ein elektrisches Netzwerk verstanden werden, welches ausgebildet ist, diese Personenschutzeinrichtung mit elektrischer Betriebsenergie zu versorgen. Das Gesamtversorgungsnetz kann auch Netze zu anderen elektrischen Verbrauchern an unterschiedlichen Orten im Fahrzeug aufweisen.

Unter einer Ladeeinheit kann beispielsweise ein Stromregler oder Spannungsregler verstanden werden, der einen Energiezwischenspeicher mit elektrischer Energie aus dem Versorgungsnetz im Steuergerät der Personenschutzeinrichtung auflädt. Unter einer Personenschutzeinrichtung kann ein System aus Steuergerät/en welches im Zusammenspiel mit internen wie externen Sensoren im Falle eines definierten Events z. B. Crash verschiedenartige Schutzelemente (devices) in geeigneter Weise aktiviert verstanden werden, um Verletzungen einer Person entweder im Fahrzeug oder außerhalb eines Fahrzeugs zu minimieren oder zu vermeiden.

Unter dem Energiezwischenspeicher kann ein elektrisches Speicherelement wie beispielsweise ein Kondensator oder Akku verstanden werden, welcher mit elektrischer Energie aus dem Versorgungsnetz gespeist wird und die im Energiezwischenspeicher gespeicherte Energie eine Versorgung der Personenschutzeinrichtung auch bei unterbrochener Versorgung (Autarkie) über einen definierten Zeitraum sicherstellt, sowie die Energie zur Aktivierung der einzelnen Personenschutzelemente (Airbag; Gurtstraffer; .......) liefern kann.

Unter einer Primärschnittstelle kann eine Schnittstelle der Ladeeinheit zum Aufnehmen von elektrischer Leistung aus dem Versorgungsnetz verstanden werden, wogegen unter einer Sekundärschnittstelle eine Schnittstelle der Ladeeinheit zum Abgeben von elektrischer Leistung und Energie an den Energiezwischenspeicher verstanden werden kann. Unter einem Einprägen eines Ladestromwertes kann die Einstellung eines Stromflusses mit einem bestimmten Wert (der auch den Wert Null Ampere einschließt) an der Sekundärschnittstelle verstanden werden.

Der hier vorgestellte Ansatz basiert auf der Erkenntnis, dass durch technisch sehr einfach umzusetzende zusätzliche Auswertungsmöglichkeiten von in oder an der Ladeeinheit bzw. deren Schnittstellen erfassten Parametern eine zusätzliche Sicherheitsfunktion implementiert werden kann. Insbesondere kann durch ein Erfassen des Stromes und/oder der Spannung an der Primärschnittstelle bei der Veränderung des Stromflusses von der Sekundärschnittstelle zum Energiezwischenspeicher eine Belastung oder eine Belastungsänderung bei einer Energieentnahme aus dem Versorgungsnetz bewirkt werden. Über diese Belastungsänderung lässt sich dann auch ein Rückschluss auf den Innenwiderstand des Versorgungsnetzes ziehen, der beispielsweise einen Hinweis auf eine schlechte elektrische Verbindung in Klemmen von Anschlussleitungen ermöglicht.

Der hier vorgestellte Ansatz bietet den Vorteil, dass durch eine vorteilhafte Verknüpfung von meist bereits vorhandenen oder messbaren Parametern ohne das Erfordernis eines zusätzlichen Sensors eine Möglichkeit besteht, die Qualität einer elektrischen Verbindung in Anschlussleitungen der Ladeeinheit bzw. eine mit der Ladeeinheit ausgestatteten Personenschutzeinrichtung zu überprüfen. Aus der bestimmten Qualität der elektrischen Verbindung kann dann beispielsweise auf das Vorhandensein von korrodierten Anschlüssen geschlossen werden, wenn der Innenwiderstand des Versorgungsnetzes einen bestimmten Schwellwert überschreitet. In diesem Fall kann eine Fehlermeldung ausgegeben werden, um den Nutzer des Fahrzeugs zu einem Werkstattbesuch zu motivieren, um diesen Fehler, beispielsweise eine korrodierte Verbindung zu ersetzen oder zu reinigen.

Günstig ist eine Ausführungsform der vorliegenden Erfindung, bei der im Schritt des Ermittelns der Innenwiderstand unter Verwendung eines Wirkungsgrades der Ladeeinheit, die primär Stromänderung beim Übergang von einem ersten zu einem zweiten sekundär Ladestromwert bestimmt wird. Eine solche Ausführungsform der vorliegenden Erfindung ermöglicht die Ermittlung des Innenwiderstandes des Versorgungsnetzes auf der Basis von nur sehr wenigen gemessenen Parametern. Auf diese Weise wird die Wahrscheinlichkeit eines fehlerhaft bestimmten Innenwiderstandes auf der Basis eines Messfehlers weitgehend reduziert.

Gemäß einer anderen Ausführungsform der vorliegenden Erfindung kann im Schritt des Erfassens eines ersten sekundär Ladestromwertes und/oder im Schritt des Bestimmens während des Aufprägens eines zweiten sekundär Ladestromwertes die Spannung an der Primärschnittstelle tiefpassgefiltert werden. Eine solche Ausführungsform der vorliegenden Erfindung bietet den Vorteil, dass kurzzeitige Schwankungen des Stroms und/oder der Spannung während der Messung unbeachtlich bleiben, sodass sich die Wahrscheinlichkeit eines fehlerhaft bestimmten Innenwiderstandes des Versorgungsnetzes signifikant reduziert.

Denkbar ist ferner eine Ausführungsform der vorliegenden Erfindung, bei der ein zweiter sekundär Ladestromwert eingeprägt wird, der größer als der erste Ladestromwert ist. Dabei kann insbesondere der zweite Ladestromwert im Vergleich zum ersten Ladestromwert derart gewählt werden, dass aus Spannungsänderung und/oder erfasster Stromänderung an der Primärschnittstelle beim Übergang vom Ladestromwert 1 zum höheren Ladestromwert 2 auf der Sekundärseite, im Schritt des Bestimmens ein Innenwiderstand bestimmbar ist, der kleiner als ein vorbestimmter Innenwiderstand des Versorgungsnetzes im fehlerfreien Fall sein muss.

Eine solche Ausführungsform der vorliegenden Erfindung bietet den Vorteil einer Möglichkeit der besonders präzisen Bestimmung des Innenwiderstandes des Versorgungsnetzes. Insbesondere kann durch die Wahl des zweiten Ladestromwertes im Bezug zum ersten Ladestromwert erreicht werden, dass an der Primärschnittstelle die jeweilige Stromänderung und/oder die jeweilige Spannungsänderung (im Fehler Fall) ausreichend groß sind, sodass auch kleine Werte des Innenwiderstandes des Versorgungsnetzes ausreichend genau aufgelöst werden können.

Gemäß einer weiteren Ausführungsform der vorliegenden Erfindung kann die Vorgabe des zweiten sekundär Ladestromwertes nach einer vorbestimmten Zeitspanne zur Vorgabe des ersten sekundär Ladestromwertes erfolgen.

Beispielsweise kann der zweite Ladestromwert innerhalb einer Zeitspanne von 1 Milli Sekunde bis 100 Milli Sekunden nach dem Einprägen des ersten Ladestromwerts an der Sekundärschnittstelle erfolgen. Eine solche Ausführungsform der vorliegenden Erfindung bietet den Vorteil, eine Veränderung von Parametern des Versorgungsnetzes, wie beispielsweise eine Erhöhung einer Batterietemperatur mit einhergehender Veränderung des Innenwiderstandes des Versorgungsnetzes, möglichst gering zu halten.

Technisch besonders einfach implementiert werden kann eine Ausführungsform der vorliegenden Erfindung, bei der im Schritt des Bestimmens der Innenwiderstand unter Verwendung einer Nachschlagetabelle bestimmt wird und/oder wobei in einem Schritt des Erfassens der Strom und oder die Stromänderung an der Primärschnittstelle unter Verwendung einer Nachschlagetabelle bestimmt werden. Bei einer solchen Ausführungsform der vorliegenden Erfindung kann auf die Ausführung von numerisch oder schaltungstechnisch zeitaufwendigen und energieaufwendigen mathematische Operationen verzichtet werden.

Weiterhin können gemäß einer Ausführungsform der vorliegenden Erfindung die Schritte des Erfassens während der Vorgabe eines ersten Sekundärstromes, des Erfassens während der Vorgabe eines zweiten Sekundärstromwertes mehrfach zeitlich nacheinander ausgeführt werden und die Innenwiderstandsberechnung nach jedem Teilschritt erfolgen, welche final aus den gespeicherten Teilergebnissen nach einem mathematischen Algorithmus (Mittelung; Verwerfung von Ausreißern etc.) zur Bestimmung des finalen Innenwiderstandes führt oder die Innenwiderstandsberechnung wird direkt aus den gespeicherten Rohwerten von Primärstrom und Primärspannung der Teilschritte nach einem mathematischen Algorithmus (Mittelung; Verwerfung von Ausreißern etc.) ausgeführt. Eine solche Ausführungsform der vorliegenden Erfindung bietet den Vorteil, dass bei der Bestimmung des Innenwiderstandes des Versorgungsnetzes zufällige Störungen oder Sondererscheinungen, beispielsweise nach langem Fahrzeug-Stillstandzeiten, möglichst ausgeschlossen werden können.

Besonders vorteilhaft ist eine Ausführungsform der vorliegenden Erfindung als Verfahren zur Ausgabe einer Fehlermeldung zur Information über eine Fehlfunktion eines Versorgungsnetzes zur statischen Energieversorgung einer Personenschutzeinrichtung eines Fahrzeugs insbesondere dem elektronischen Steuergerät dieser Einrichtung, wobei das Verfahren die folgenden Schritte aufweist:

- die Schritte eines Verfahrens gemäß einer hier vorzustellenden Variante; und
- Bereitstellen der Fehlermeldung, wenn der Innenwiderstand in einer vorbestimmten Beziehung zu einer Widerstandsschwelle steht.

Eine solche Ausführungsform der vorliegenden Erfindung bietet den Vorteil einer frühzeitigen Warnung, wenn der Innenwiderstand ein bestimmtes Kriterium oder eine vorbestimmten Beziehung zu einer Widerstandsschwelle erfüllt, beispielsweise wenn der Innenwiderstand des Versorgungsnetzes größer als die Widerstandsschwelle ist. Auf diese Weise kann dann beispielsweise ein Rückschluss auf eine schlechte Qualität einer elektrischen Verbindung in einem Stecker oder einem Anschluss Kontakt des Versorgungsnetzes gezogen werden, sodass möglicherweise eine Funktion des elektronischen Steuergerätes der Personenschutzeinrichtung wie z. B. reduzierte Robustheit im Falle von Zündkreiskurzschlüssen durch "Ground Shift" oder reduzierte Performance der redundanten Aktivierung von Personenschutzmitteln (Devices wie Airbag, Gurtstraffer etc.) aus dem Versorgungsnetz nicht mehr korrekt ausgeführt werden kann.

Günstig ist auch eine Ausführungsform der vorliegenden Erfindung als Vorrichtung zum Ermitteln eines Innenwiderstandes eines Versorgungsnetzes zur Energieversorgung einer Personenschutzeinrichtung eines Fahrzeugs. Dabei kann das elektronische Steuergerät dieser Einrichtung eine Ladeeinheit umfassen die mittels einer Primärschnittstelle mit dem Versorgungsnetz und mittels einer Sekundärschnittstelle mit dem Energiezwischenspeicher zur Zwischenspeicherung von Energie für die Autarkieversorgung der Personenschutzeinrichtung z. B. im Crash sowie zur Bereitstellung der Aktivierungsenergie von Personenschutzmitteln der Personenschutzeinrichtung nach einer Trennung der Personenschutzeinrichtung (hier des elektronischen Steuergerätes) von dem Versorgungsnetz verbunden sein. Die Vorrichtung umfasst die folgenden Merkmale:

- eine Einheit zum Einprägen eines ersten Ladestromwertes an der Sekundärschnittstelle einschließlich Null (kein Strom);
- eine Einheit zum Erfassen eines Stromes und/oder einer Spannung an der Primärschnittstelle während des Einprägens;
- eine Einheit zum Einprägen eines von dem ersten Ladestromwert unterschiedlichen zweiten Ladestromwertes an der Sekundärschnittstelle;
- eine Einheit zum Erfassen eines Stromes und/oder einer Spannung an der Primärschnittstelle während des Einprägens des zweiten Sekundärladestromwertes ; und
- eine Einheit zum Bestimmen des Innenwiderstandes des Versorgungsnetzes unter Verwendung des erfassten Stromes oder des über eine physikalische Beziehung aus Kenntnis der Höhe des eingeprägten Sekundärstromes ermittelten Primärstromes bzw. dessen Änderung zu einem designabhängigen Offset und/oder der erfassten Spannung während des Schrittes des Einprägens eines ersten Sekundärstromwertes und unter Verwendung des erfassten Stromes oder des über eine physikalische Beziehung aus Kenntnis der Höhe des eingeprägten Sekundärstromes ermittelten Primärstromes bzw. dessen Änderung zu einem designabhängigen Offset und/oder der erfassten Spannung während des Schrittes Einprägens eines zweiten Sekundärstromwertes.

Der hier vorgestellte Ansatz schafft somit ferner eine Vorrichtung, die ausgebildet ist, um die Schritte einer Variante eines hier vorgestellten Verfahrens in entsprechenden Einrichtungen durchzuführen bzw. umzusetzen. Auch durch diese Ausführungsvariante der Erfindung in Form einer Vorrichtung kann die der Erfindung zugrunde liegende Aufgabe schnell und effizient gelöst werden.

Unter einer Vorrichtung kann vorliegend ein elektrisches Gerät (elektronisches Steuergerät einer Personenschutzvorrichtung) verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird. Die vorliegende Erfindung schafft somit gemäß einer Ausführungsform auch ein Computer-Programmprodukt mit Programmcode zur Durchführung des Verfahrens nach einer hier vorgestellten Variante, wenn das Programmprodukt auf einer Vorrichtung ausgeführt wird.

Der hier vorgestellte Ansatz wird nachstehend anhand der beigefügten Zeichnungen beispielhaft näher erläutert. Es zeigen:

Fig. 1    ein Schaltbild einer Vorrichtung zur Verwendung in einem Ausführungsbeispiel der vorliegenden Erfindung;

Fig. 2    ein Schaltbild einer Vorrichtung zur Verwendung in einem Ausführungsbeispiel der vorliegenden Erfindung;

Fig. 3    ein Diagramm eines zeitlichen Verlaufs von Spannungen oder Strömen als Signalverlauf der zur Bordnetzinnenwiderstandsmessung notwendigen Signale;

Fig. 4    einen Schaltplan einer Energieversorgungsschaltung zur Verwendung in einem weiteren Ausführungsbeispiel der vorliegenden Erfindung.

Fig. 5    ein Schaltplan einer geeigneten Ladestromquelle für den Energiezwischenspeicher bzw. einer Energieversorgungsschaltung zur Verwendung in einem Ausführungsbeispiel der vorliegenden Erfindung; und

Fig. 6    ein Ablaufdiagramm eines Ausführungsbeispiels der vorliegenden Erfindung als Verfahren.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

Ein Aspekt der Erfindung ist darin zu sehen, eine Möglichkeit zu schaffen durch Erkennung beispielsweise eines zu hohen Versorgungsinnenwiderstandes eines Bordnetzes (Teilnetzes) (als Versorgungsnetz eines Fahrzeugs, hier des sicherheitsrelevanten Versorgungsnetzes einer Personenschutzeinrichtung) einen gezielten Service- bzw. Wartungsaufenthalt in einer Werkstatt zu erzwingen und einen sicherheitsrelevanten Einfluss auszuschließen, insbesondere bei Systemen ohne redundante Versorgungsanbindung (wie dies beispielsweise bei einem Vollkunststoffgehäuse, Karbon Chassis oder dergleichen der Fall ist). Dabei ist in der Regel, die der Korrosion ausgesetzte Masseanbindung eine wichtige Fehlerquelle.

Durch Erkennung kritischer (d. h. zu hoher) Innenwiderstände beispielsweise der Fahrzeug-Airbag-Versorgung kann die Robustheit des Systems gegen Systemfehler erhöht werden. Insbesondere werden die negativen Auswirkungen zu hoher Masse-Widerstände der Airbag-Versorgung auf Kurzschlüsse an Zündkreisen vermieden (Fehlströme über Zündpillen). Dadurch kann die Robustheit von großen Airbag-Systemen, insbesondere integrierter safety units, mit hoher Stromaufnahme auf den Stand heutiger kleiner Airbag Systeme in Bezug auf Nebenschlüsse an Zündkreisen gebracht werden, ohne das redundante Versorgungspfade nötig wären.

Airbag-Systeme können beispielsweise auf redundante Versorgungsanbindung insbesondere der Masse verzichten. Dies bringt Vorteile für die GehäuseKonstruktion (z. B. Vollkunststoff oder durch Verwendung der Masseanbindung über die Steckverbindung bei Chassis aus Karbon etc.). Ebenso wird rechtzeitig erkannt ob back-up-Strukturen zur Rückhaltemittel-Aktivierung (firing) aus der Fahrzeugbatterie (nicht der Energiereserve) wirksam wären.

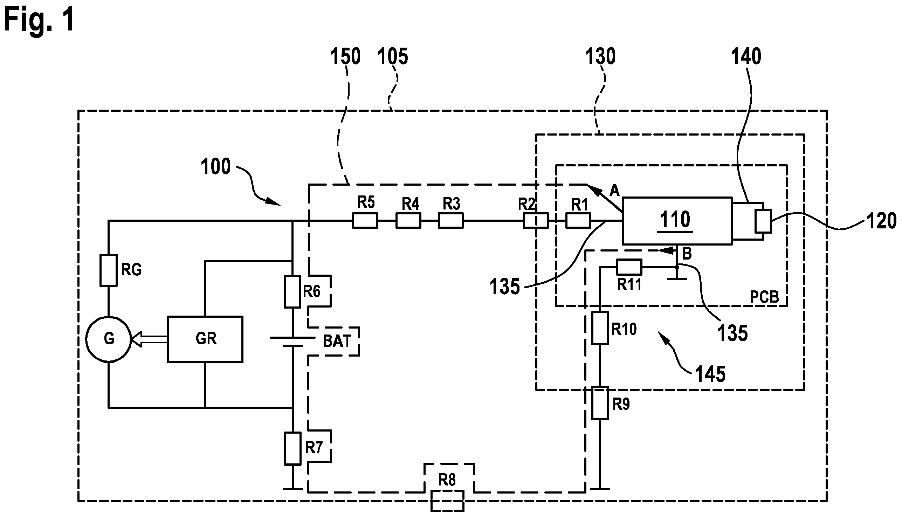

Fig. 1 zeigt einen beispielhaften Schaltplan eines Versorgungsnetzes 100 eines Fahrzeugs 105, welches mit einer Ladeeinheit 110 eines Energiezwischenspeichers 120 einer Personenschutzeinheit 130 z. B. ein elektronisches Steuergerät als Teil einer Personenschutzeinrichtung, verbunden ist. Dabei ist die Ladeeinheit 110 (die hier als Teil eines Airbag-(Steuergeräte)-Versorgungs-ASICs ausgestaltet ist) über eine Primärschnittstelle 135 mit den Anschlusspunkten A und B mit dem Versorgungsnetz 100 verbunden. Ferner ist die Ladeeinheit 110 mittels der Sekundärschnittstelle 140 mit dem Energiezwischenspeicher 120 verbunden, welcher zusammen mit der Ladeeinheit 110 auf einer gemeinsamen Leiterplatte PCB angeordnet ist. Diese Leiterplatte PCB kann auf einem Bodenblech 145 angeordnet sein. Das Versorgungsnetz 100 weist einen Generator G, einen Generatorinnenwiderstand RG und einen Generatorregler GR auf, die eine Batterie BAT (beispielsweise einen Akku als Fahrzeugbatterie) auf eine gewisse Spannung aufzuladen.

In Fig. 1 zeigt dabei eine Übersicht, welcher Bordnetzinnenwiderstand mit dem hier vorgestellten Ansatz bestimmt werden soll. Es wird die Summe aller Widerstände zwischen dem Plus-Anschluss A und dem Masse-Anschluss B des Steuergerätes bzw. der Ladeeinheit 110 bestimmt. Mit anderen Worten ausgedrückt, wird der Innenwiderstand des Versorgungsnetzes 100 an der Primärschnittstelle 135 bestimmt. Dieser Innenwiderstand umfasst die Summe aller Widerstände zwischen den Punkten A und B. Insbesondere umfasst der zu bestimmende Innenwiderstand entlang des Messpfades 150 damit die Widerstände:

R1: $\Sigma$ aller R's auf PCB vom Stecker der Steuergerät Plus-Versorgung bis Airbag-(Steuergeräte)-Schaltkreis-Versorgung (z. B. Track Widerstand;..)
R2: $\Sigma$ aller Kontaktwiderstände der Steckverbindung UBAT zur Leiterplatte (z. B. Steckkontakt; Einpresskontakt)
R3: $\Sigma$ aller Cu-Widerstände der Kabel UBAT Verbindung vom Batterie-Plusanschluss bis Airbag Steuergeräte UBAT+Steckerpin
R4: $\Sigma$ aller Widerstände der Sicherungen in der Zuleitung
R5: $\Sigma$ aller Kontaktwiderstände in der UBAT-+ Verbindung zur Batterie (Zündschloss; Anschlusssicherung....)
R6/RG: (Wirksam ist R6) Innenwiderstand der Fahrzeugbatterie (im Falle Motor aus, Generator Stillstand) oder RG Innenwiderstand des Generators in Falle Motor an, Generator läuft)
R7: Übergangswiderstand Batterie/Generator -Masseanschluss zum Chassis
R8: Chassisinnenwiderstand
R9: Übergangswiderstand Fahrzeug-Chassis zum Steuergerät-Bodenblech
R10: $\Sigma$ aller Kontaktwiderstände Steuergerät-Bodenblech zum PCB-Masseanschluss
R11: $\Sigma$ aller R's vom PCB-Masseanschluss bis zur Masse-Versorgung des Versorgungs-Schaltkreises (z. B. Track, Widerstand..;..)

Damit werden alle Änderungen von Widerständen erfasst. In der Realität sind vor allem die Kontaktwiderstände eine Fehlerquelle, insbesondere diese, die einer erhöhten Korrosion ausgesetzt sind (wie z. B. Masseanbindungen gegenüber dem Fahrzeug Chassis).

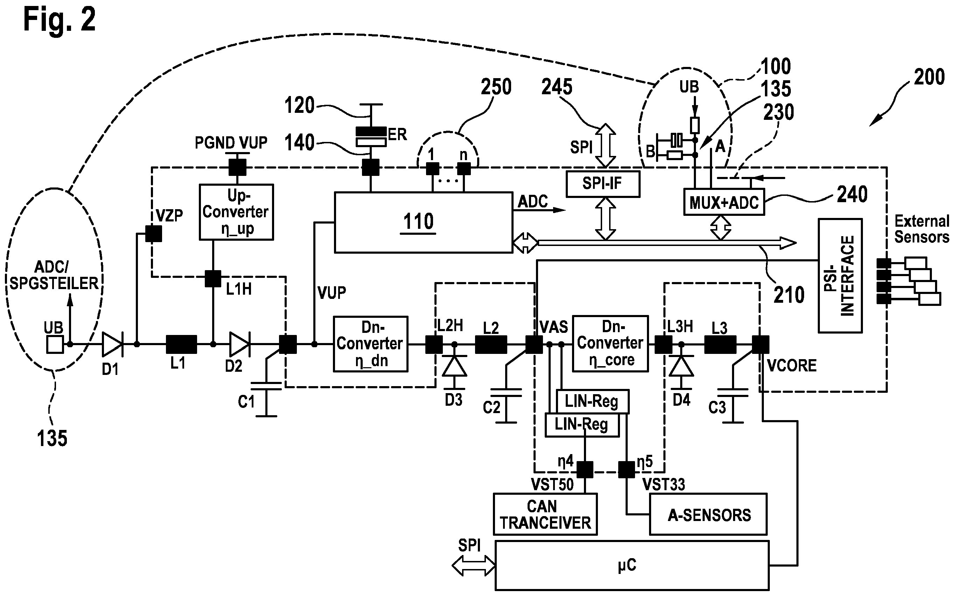

Fig. 2 zeigt ein Schaltbild einer Energieversorgungsschaltung 200 mit einer Ladeeinheit 110 zur Verwendung in einem Ausführungsbeispiel der vorliegenden Erfindung. Die Ladeeinheit 110 ist über die Sekundärschnittstelle 140 mit dem Energiezwischenspeicher 120, der auch mit dem Kürzel ER bezeichnet werden kann, verbunden ist. Die Primärschnittstelle 135 ist links in der Fig. 1 abgebildet. Die reine Spannungsmessung (UB) erfolgt über das Tiefpassfilter Mux + ADC. Ist neben der reinen Spannungsmessung UB bei komplexen nicht durch Tabellen hinterlegbaren Zusammenhängen zwischen Primär und Sekundärstrom eine Primär-Strommessung notwendig, wird hier ein Shunt in die Primär-Versorgungsleitung eingefügt und ein weiterer Spannungsmesskanal über einen zweiten identischen Tiefpass an einen zweiten MUX-Kanal des ADC geführt. Dabei umfasst die Energieversorgungsschaltung 200 mehrere Einheiten, wie beispielsweise einen regelbaren Abwärtswandler (Dn Converter) zur Erzeugung der Systemspannung VA S, notwendig für die Sensor Interface-Versorgung entsprechend dem PSI-Standard, einen regelbaren Aufwärtswandler Up Converter zur Bereitstellung eines hohen Spannungsniveaus (VUP= 20V...50V) zur optimalen Energiespeicherung, einer Energiereserve, zumindest einen Beschleunigungssensor A_Sensor, einen Mikrocontroller $\mu$C, eine SPI-Schnittstelle SPI. Die Energieversorgungsschaltungen weisen dabei eine Effizienz von allgemein $\eta$x auf z. B. (n_up für den Aufwärtswandler, n_dn für den VAS-Abwärtswandler, etc.)

Ferner ist die Ladeeinheit 110 über einen ASIC-internen Bus 210 an dem weitere ASIC-Funktionsblöcke wie z. B. der zentrale Multiplexer+ADC angeschlossen sind mit dem SPI Interface (Serial Peripheral Interface) 245 verbunden.

Des Weiteren werden analoge Messgrößen (Signale) insbesondere die Energiereservespannung und optional der Ladestrom der Ladeeinheit an den Multiplexer+ADC (240) gegeben.

Die aus dem Versorgungsnetz 100 gelieferte elektrische Energie kann über die Verpolschutzdiode D1 den Aufwärtswandler und dessen externen Komponenten z.B. L1 und D2 die Ladeeinheit 110 sowie parallel den VAS-Abwärtswandler versorgen. Ebenso kann aus dem Versorgungsnetz ein redundanter Versorgungspfad zur Aktivierung der Personenschutzmitteln vom Anschluss UB im Steuergerät abzweigen.

Der Anschluss UB des Steuergerätes mit der Energieversorgung 200 erfasst über ein Tiefpassfilter 220 beispielsweise durch einen Widerstands-Spannungsteiler mit einer Kapazität zwischen einem Anschlusspunkt A und einem Massepotenzial B gebildet (integriert oder teilintegriert in den Airbag Steuergeräte System-ASIC) die Versorgungsspannung UB über den angeschlossenen Multiplexer + ADC 240. Dadurch lässt sich der UB-Spannungsmesswert auf SPI Befehl des µC über den ASIC internen Bus 210 und die SPI-Schnittstelle an den µC übertragen.

Optional kann über weitere Eingangs-Messkanäle des Multiplexers auch eine Differenzspannungsmessung über einen niederohmigen Shunt, der vor oder nach der Diode D1 in Serie in die UB/VZP Leitung geschaltet wird ausgeführt werden und damit der Versorgungsstrom unmittelbar aus der Differenzspannungsmessung bestimmt werden. Aus der Messung der Versorgungsspannung UB und des optional gemessenen Eingangsstromes lässt sich die Leistungs- bzw. die Energieaufnahme durch Integration über die Zeit im µC direkt bestimmen.

Fehlt die optionale Strommessung, kann die Änderung der Primärstromaufnahme aus der Änderung der Stromabgabe des Ladeeinheit 110 über den Wirkungsgrad des Aufwärtswandlers η_up bestimmt werden, sofern die Steuergeräteauslegung sicherstellt, dass der Strombedarf über den VAS-Abwärtswandler konstant bleibt. Damit kann dann final die Änderung der Leitungsaufnahme aus dem Versorgungsnetz bestimmt werden.

Hierzu ist die Ladeeinheit 110 programmierbar oder steuerbar, beispielsweise derart, dass unterschiedliche Ladestromwerte (IER) zu unterschiedlichen Zeitpunkten an der Sekundärschnittstelle 140 eingeprägt werden können. Dies bedeutet, dass die Ladeeinheit 110 derart gesteuert wird, dass über die Sekundärschnittstelle 140 unterschiedlich große Ströme in den Energiezwischenspeicher 120 fließen und damit die Ladegeschwindigkeit steigt oder sinkt. Beispielsweise kann die Programmierung oder Steuerung dieses Stromladeverhaltens an der Sekundärschnittstelle 140 über mehrere Programmieranschlüsse 250 die parallel mit I/Os des µC verbunden sind erfolgen oder über µC SPI Befehle, die an die Ladeeinheit übertragen werden oder jede andere Art von Befehlsübermittlung des µC an die Ladeeinheit. Diese unterschiedlichen Ladestromwerte IER der Sekundärschnittstelle wirken sich dadurch aus, dass auch an der Primärschnittstelle in der UB-Zuleitung zu D1 unterschiedliche Ströme IBAT und/oder Spannungen UBAT (beobachtet über die Tiefpassgefilterten Analog-Messkanäle 135) zu den unterschiedlichen Zeitpunkten auftreten.

Zur Ermittlung des Versorgungsinnenwiderstandes R sollte eine Airbag-Steuergeräteversorgungsspannungsmessung bei einem Eingangsstrom I1{IBAT(t1)} und bei einem Eingangsstrom I2{IBAT(t2)} zeitlich nahe beieinanderliegend an den Zeitpunkten t1 und t2 an der Primärschnittstelle 135 durchgeführt werden. Die Differenz der Eingangsströme I1, I2 sollte so groß gewählt sein, dass relevante Widerstände (0.5... 1.5) Ω auflösbar sind. Die Auflösungsgrenze sollte für Airbag Systeme bei <= 100 mΩ liegen.

Zum Schutz der Messung gegen Störspannungen, Lastwechsel im Bordnetz etc. ist diese geeignet zu filtern. Hierzu gehören neben dem Tiefpassfilter 220 beispielsweise eine mehrfache (>=3) schnelle Wiederholung der Messung mit Kontrolle der Eingangsspannung vor und nach der Messung.

Außerdem ist eine Filterung des Fehlers über mehrere Startvorgänge geeignet, um zufällige Störungen oder Sondererscheinungen nach langen Fahrzeug-Stillstandszeiten auszuschließen.

Gemäß einem ersten Ausführungsbeispiel der vorliegenden Erfindung kann der Innenwiderstand des Versorgungsnetzes sehr günstig erfasst werden. In Airbag-Steuergeräten, die über einen Aufwärtswandler zur Erzeugung einer geregelten Ausgangsspannung VUP (20...50)V z.B. 33V aus der verpolungsgeschützten Fahrzeugspannung VZP (5...20)V verfügen, und daraus zum einen, über einen Abwärtswandler eine geregelte Ausgangsspannung VAS (6...8)V z.B. 6.7V bereitstellen, zur weiteren verlustarmen Generierung der nötigen Systemspannungen (5V; 3.3V; 1.2V... etc..) und zum anderen über einen EIN/AUS-schaltbaren Energiereserve-Ladestromregler zur Ladung der ER aus VUP verfügen, bilden dabei die bekannte Lösungsbasis.

Der hier vorgeschlagene Ansatz ergänzt im Bereich der Hardware diese Basis durch einen neuen, wählbaren Energiereserve-Ladestromwert, der den Anforderungen zur Ermittlung des Versorgungsinnenwiderstandes R entsprechend der Darstellung aus Fig. 1 genügt, ohne eine komplett neue Messeinrichtung an den Versorgungsklemmen vorzusehen.

Das heißt, der Energiereserve-Ladestromregler (d. h. die Ladeeinheit 110) ist so ausgeführt, dass dem Abschalten (Ladestromwert Null) mindestens zwei verschiedene Ladestrom-Regelwerte ausgewählt werden können. Ein Wert dient zur normalen Ladung der Energiereserve 120 bzw. ER entsprechend Systemanforderung, ein zweiter (beispielsweise größerer) Wert dient neben der kurzfristigen sekundären (schnelleren) Energiereserveladung, der primären Steigerung des Airbag Versorgungsstromes zur Einstellung des Stromwertes I2 für die Innenwiderstandsmessung.

In einer weiteren Optimierung lässt sich der Regelstromwert des Ladestromreglers 110 in einer bestimmten Schrittweite programmieren und dadurch auf die verschiedenen Anforderungen optimal abstimmen.

Zwischen dem Eingang und dem Ausgang eines Aufwärtswandlers gilt folgende Beziehung:

A) Pout = η x Pin -> P_vup = η_up x P_vzp

VUP = Aufwärtswandler-Ausgangsspannung,

VZP = Aufwärtswandler-Eingangsspannung,

P_vup = Aufwärtswandler-Ausgangsleistung,

P_vzp = Aufwärtswandler-Eingangsleistung

$\eta$_up ist der Wirkungsgrad des Wandlers.

In erster Näherung ist dieser konstant. Für reale Systeme ist er aber von der Eingangsspannung und dem Ausgangsstrom abhängig.

Für den Airbag Steuergeräte-Anwendungsfall genügt die Berücksichtigung der wesentlichen Spannungsabhängigkeit. Diese ist vor allem bei kleinen Eingangsspannungen VZP=5V...8V spürbar, für größere Spannungen VZP > 8V wird sie immer geringer.

Für den Airbag Anwendungsfall lässt sich der Zusammenhang A) weiter detaillieren und mit einer Einteilung von maximal 8 VZP Bereichen bis minimal 3 VZP Bereichen sehr gut bis gut approximieren:

Einteilung in 8 VZP Bereiche:

A1)

$$P\_vup = \eta\_up(5.5V ..6.0V) \times P\_vzp; \qquad z.B. \ \eta\_up \ (5.5V) = 0.7$$
$$P\_vup = \eta\_up \ (6.0V .. 6.5V) \times P\_vzp \qquad z.B. \ \eta\_up \ (6.0V) = 0.75$$
$$P\_vup = \eta\_up \ (6.5V ..7.0V) \times P\_vzp \qquad z.B. \ \eta\_up \ (6.5V) = 0.8$$
$$P\_vup = \eta\_up \ (7.0V .. 8.0V) \times P\_vzp \qquad z.B. \ \eta\_up \ (7.0V) = 0.825$$
$$P\_vup = \eta\_up \ (8.0V ..9.0V) \times P\_vzp \qquad z.B. \ \eta\_up \ (8.0V) = 0.85$$
$$P\_vup = \eta\_up \ (9.0V .. 10.0V) \times P\_Vzp \qquad z.B. \ \eta\_up \ (9.0V) = 0.875$$
$$P\_vup = \eta\_up \ (10.0V .. 12.0V) \times P\_vzp \qquad z.B. \ \eta\_up \ (10V) = 0.9$$
$$P\_vup = \eta\_up \ (>=12.0V) \times P\_vzp \qquad z.B. \ \eta\_up \ (6.5V) = 0.9125$$

Einteilung in 3 VZP Bereiche:

A2)

$$P\_vup = \eta\_up \ (5.5V ... 7.0V) \times P\_vzp ; \qquad z.B. \ \eta\_up \ (6.0V) = 0.75$$
$$P\_vup = \eta\_up \ (7.0V ... 9.0V) \times P\_Vzp ; \qquad z.B. \ \eta\_up \ (8.0V) = 0.85$$
$$P\_vup = \eta\_up \ (>=9.0V) \times P\_vzp; \qquad z.B. \ \eta\_up \ (10V) = 0.9$$

Zur Definition des ER-Ladestromwertes zur Bestimmung des Versorgungsinnenwiderstandes R ist Folgendes anzumerken:

Durch Verwendung beispielsweise eines 10-bit ADCs (d. h. des ADC aus Fig. 2) zur Versorgungsspannungsmessung im Bereich 0... (24 ... 30V) an der Primärschnittstelle 135 lassen sich eine Versorgungsspannungsauflösungen von $\delta$UBAT_ADC = (23.4 ... 29.3) mV pro Digit erreichen. Daraus ergibt sich eine Innenwiderstandsauflösung von $\delta$RBAT = $\delta$UBAT_ADC / $\delta$IBAT.

Sind $\delta$RBAT <= 100m$\Omega$ gefordert so ist A3) $\delta$IBAT= $\delta$UBAT_ADC / $\delta$RBAT (<= 100m$\Omega$) / notwendig. $\delta$IBAT ist die notwendige Stromänderung von I1 nach I2 -> $\delta$IBAT= |(I2-I1)| um bei gegebener Spannungsauflösung der UBAT-Messung einen Versorgungsinnenwiderstand gefordert aufzulösen.

Für $\delta$UBAT_ADC = 25mV und $\delta$RBAT=100m$\Omega$ folgt:

$$\delta IBAT = 25mV / 100m\Omega = 0.25A$$

Daraus lässt sich nun der neue Ladestromregelwert der Energiereserve ER über die Sekundärschnittstelle 140 zur Innenwiderstandsmessung des Innenwiderstands R bestimmen.

Um eine Erhöhung des Versorgungsstromes des Airbag-Steuergerätes bzw. der Energieversorgungsschaltung 200 zu Messzwecken gezielt einzusetzen, ist es am sinnvollsten und kostengünstigsten für das Gesamtsystem, dies durch eine Benutzung der Energiereserve-Ladestromschaltung 110 zu tun. Dadurch wird eine bereits vorhandene Einrichtung 110 nur verbessert (Kosten) und die erhöhte Energieaufnahme dient dem Zweck der Energiereserveladung.

Die Aufwärtswandlerbeziehung A) angewendet auf das Gesamtsteuergerät führt zu folgendem Zusammenhang:

B) p_ubat= p1 +p2 +p3 +p4 = p1 + p2 + (VUP x Iup_dn)/ $\eta$_up + (VUP x IER) / $\eta$_up

mit p1 = Verlustleistung der Verpolschutzdiode D1

p2 = ist die Summe aller Verbräuche aus UBAT oder VZP die primär vom Steuergerät für Hilfsfunktionen benötigt werden (z. B. Teilerquerströme der Messeinrichtung 135, Referenzströme, Kommunikations-Ströme durch pull-up Widerstände zu UBAT, VZP etc.). In der Regel ist diese Leistung klein, insbesondere kann Ihre Schwankung vernachlässigt werden.

p3 = VZP *IBAT3 = (VUP x lup_dn) / $\eta$_up stellt die Leistung dar, die im jeweiligen Betriebsfall zur Aufrechterhaltung der Funktionalität des Airbag Systems an den VASDownwandler abgegeben werden sollte. Die Airbag-Funktionalität ist während der Messung nicht auszuweiten, wodurch p3 als konstant angenommen werden kann.

p4 = VZP *IBAT4=(VUPx IER) / n_up stellt die Leistung dar, die beim Laden der Energiereserve zusätzlich am Eingang des Airbag Steuergerätes bereitgestellt werden soll um einen bestimmten Ladestrom zu erzielen.

Wird der Strom IER von 0 auf IER_TEST geändert, steigt der Strom an VZP und damit an UBAT um B1) $\delta$IBAT= VUP x IER_TEST / ($\eta$_up x VZP) an.

Beträgt zum Zeitpunkt der Innenwiderstandsmessung die Bordnetzspannung z. B. UBAT=16.5V, die Aufwärtswandler-Ausgangsspannung VUP=33V, so ist die verpolgeschützte Spannung VZP (bei Verwendung von Schottky-Dioden) um Ud = 0.5V tiefer als UBAT.

aus B1) und A2) -> B2) IER_TEST=$\delta$IBAT x [$\eta$_up x (UBAT-Ud)]/VUP -> z. B. IER_TEST= 0.25A x 0.9 x 16V/33V = 0.11A

Mit der Wahl von IER_TEST=120 mA lässt sich einschließlich weiterer Toleranzen der Eingangsstrom eines Airbag Steuergerätes mindestens um den geforderten Wert anheben, um eine bestimmte Innenwiderstandsauflösung der Bordnetzversorgung von z. B. <=100m$\Omega$ zu erreichen.

Sind andere Anforderungen gegeben, kann entsprechend den dargestellten Zusammenhängen ein notwendiger Ladestromsprung der Energiereserve gefunden werden.

Nachfolgend wird ein exemplarischer Messablauf zur Bordnetzinnenwiderstandsbestimmung vorgestellt, der als beispielhaftes Steuerungsprogramm der Ladeeinheit 110 verstanden werden kann:

1) Steuergerät bzw. die Ladeeinheit 110 befindet sich in der INIT-Phase (Mess-Schleifen RAM-Zähler wurde zum Start des Steuergerätes resitiert (=0 gesetzt)

2) Prüfung Mess-Schleifen RAM-Zähler (MS-RAM-Zähler)
(erzwingt bis zu 3 aufeinanderfolgende Messdurchläufe falls Messung nicht auswertbar)
MS-RAM-Zähler = MS-RAM-Zähler +1 <=3? Falls ja, Messung ausführen, falls nein abbrechen und
FLASH bzw. EEPROM Festwertspeicher Fehlerzähler "BORDNETZINNENWIDERSTAND R zu hoch" nicht verändern; Programm mit Prüfung des Fehlerzählers "BORDNETZINNENWIDERSTAND R zu hoch" im Schritt 21) fortsetzen.

3) Plausibilität der VER; Energiereserve ist geprüft aber nicht vollständig geladen Ist VER(t0) <=25V?, falls ja Messung starten -> 4), falls nein abbrechen -> 21)

4) Vorbereitung: Einstellung der LIN/K-Line Kommunikation
Einstellung aller Zündkreismessungen
Alle externen Sensoren sind abgeschaltet.

5) Ladestromregler der Energiereserve ausschalten (lup_ER(t1)=0

6) Wartezeit zur Einstellung stabiler Verhältnisse

7) Messung der Aufwärtswandler-Ausgangsspannung VUP(t2)

8) Wartezeit zur Einstellung eines stabilen Eingangsstromes (Anfangswert)

9) Messung der Airbag-Versorgungsspannung UBAT(t3)

10) Ladestromregler der Energiereserve einschalten /programmieren IER(t4)=IER_TEST)

11) Wartezeit zur Einstellung eines höheren stabilen Eingangsstromes

12) Messung der Airbag Versorgungsspannung UBAT(t5)

13) Ladestromregler der Energiereserve ausschalten (lup_ER(t6)=0)

14) Wartezeit zur Einstellung eines niederen stabilen Eingangsstromes (Anfangswert)

15) Messung der Airbag-Versorgungsspannung UBAT(t7)

16) Plausibilitätsauswertung Konstanz der Versorgungsspannung während der Messung
Ist UBAT(t7) = UBAT(t3) +/- (0 ... 2LSB) ? falls ja -> (J), falls nein (N)
(N) es liegt eine Spannungsstörung vor, Messung kann nicht ausgeführt werden -> abbrechen zu 2) gehen
(J) es liegt keine Spannungs-Störung vor!, zum nächsten Programmschritt 17) gehen

17) Plausibilitätsauswertung Spannungsdifferenz der Versorgungsspannung Ist UBAT(t3) - UBAT(t5) >2LSB ? falls ja -> (JJ); falls Nein (NN)
(NN) Messung ist super gut oder nicht auswertbar -> abbrechen zu 2) gehen (JJ) Messung ist auswertbar, zum nächsten Programmschritt 18) gehen

18) Bordnetzinnenwiderstand R prüfen und Fehlerzähler anpassen Einlesen der Innenwiderstandsfehlergrenze aus einem Daten (FestwertSpeicher (FLASH; EEPROM etc.) z. B. 1$\Omega$:
Prüfung ob Fehlergrenze (Widerstandsschwelle) nicht überschritten ist:
R=[UBAT(t3) - UBAT(t5)] / $\delta$IBAT <= 1$\Omega$ ? falls Ja (JJJ); falls nein (NNN) (NNN) Bordnetzinnenwiderstand ist zu hoch, -> zu 19) gehen
Vorgehensweise bei der Innenwiderstandsprüfung:
mit B2) folgt
R = [UBAT(t3) - UBAT(t5)] / [(IER_TEST x VUP) / {(UBAT(t5)-Ud) x $\eta$_up}]
R = [UBAT(t3) - UBAT(t5)] x {(UBAT(t5)-Ud) x $\eta$_up(i)} / (IER_TEST VUP) Entnahme n_up(i) aus gespeicherter (Daten (Festwert)-Speicher) Wirkungsgradtabelle mit der Eingangsgröße UBAT(t5) (siehe A2)):
z. B.
Für 5.9 V < UBAT(t5) <= 7,4V -> $\eta$_up(I) = 0.75
Für 7,4 V < UBAT(t5) <= 9,4V -> $\eta$_up(II) = 0.85
Für 9,4V < UBAT(t5) -> $\eta$_up(III) = 0.9
Beispiel: mit VUP=33V; IER_TEST=120mA; Ud=0.5V;
UBAT(t5) - UBAT(t3) =0.4V; UBAT(t5)=9V folgt:
R= 0,4V x (9V-0.5V) x 0.85 / 0.12A x 33V
R= 2.89V$^2$ / 3.96AV =0.73 $\Omega$ <= 1 $\Omega$ !
(JJJ) Der Bordnetzinnenwiderstand des Fahrzeugs zur Airbag Versorgung ist in Ordnung -> zum nächsten Programmschritt 20) gehen

19) FLASH/EEPROM-Fehlerzähler "Bordnetzinnenwiderstand zu hoch" um 1 Stufe inkrementieren (da zu hoch) und Programm in Schritt 21 fortsetzen

20) FLASH/EEPROM-Fehlerzähler "Bordnetzinnenwiderstand zu hoch" um 1 Stufe dekrementieren (da nicht zu hoch) (falls >=1), sonst nicht und Programm in Schritt 21 fortsetzen

21) FLASH/EEPROM-Fehlerzähler prüfen
Ist Fehlerzähler "Bordnetzinnenwiderstand >=1$\Omega$" >=10 ?, falls Ja (JJJJ); falls nein (NNNN)
(NNNN) keine Statusänderung der Warnlampe, es liegt kein erhöhter gefilterter Bordnetzinnenwiderstand vor $\rightarrow$ nach 23) gehen

22) (JJJJ) Er liegt ein erhöhter gefilterter Bordnetzwiderstand vor.
Airbag Warnlampe auf aktiv (ON) setzen zu 23) gehen

23) Messprogramm Bordnetzinnenwiderstand zu hoch ENDE
Weiteres Programm fortsetzen

Lösung 1a) Der Fehlerzähler kann unterschiedlich inkrementiert oder dekrementiert werden

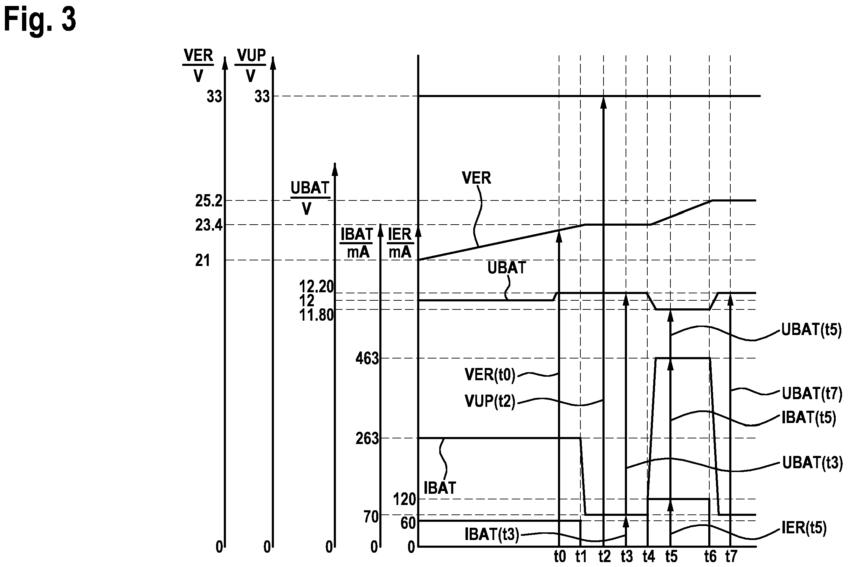

Im Diagramm aus Fig. 3 sind anhand des dargestellten zeitlichen Verlaufs von Spannungen oder Strömen der genaue Signalverlauf der zur Bordnetzinnenwiderstandsmessung notwendigen Signale dargestellt. Zu Beginn befindet sich das System nach Versorgungsstart in Ladephase der Energiereserve, z. B. IER=60mA. Zum Zeitpunkt t0 wird die ER Spannung VER geprüft, um sicherzustellen, dass noch Ladestrom zur Messung des Innenwiderstandes aufgenommen werden kann. Zum Zeitpunkt t1 wird die Ladung der Energiereserve abgeschaltet, wodurch VER nicht mehr steigt und sich die Versorgungsspannung bei endlichem Innenwiderstand erhöht. Das Steuergerät nimmt jetzt den niedrigsten Versorgungsstrom auf. Zu Kontrollzwecken kann zum Zeitpunkt t2 oder auch an einer anderen geeigneten Stelle, die Ausgangsspannung des Aufwärtswandlers gemessen werden (in der Regel unveränderbar, da geregelt). Danach wird die Batteriespannung UBAT zum Zeitpunkt t3 bei niedrigem Eingangsstrom IBAT(t3) gemessen. Zum Zeitpunkt t4 wird der ER-Ladestrom-Regler auf einen hohen Wert eingestellt (programmiert, etc.) z. B. IER(t4)=120mA. Dadurch steigt der Versorgungsstrom des Steuergerätes definiert stark an. Die Batteriespannung nimmt dagegen bei endlichem Innenwiderstand ab. Zum Zeitpunkt t5 wird UBAT gemessen.

Aus der Differenz UBAT(t3) und UBAT(t5) lässt sich nun auf den Innenwiderstand schließen (z. B. mit einer im μC gespeicherten Tabelle, die für jeden gemessenen Wert UBAT(t5) einen Grenzwert für UBAT(t3)-UBAT(t5) vorgibt). Mit dem Ende der Messung wird der ER-Lade-Strom-Regler 110 wieder abgeschaltet (IER=0mA) um auf Störungen während der Messzeit zu prüfen. Gilt UBAT(t7) = UBAT(t3) ist kein Hinweis auf eine Störung vorhanden. (Die Zeit t7 - t3 sollte klein gehalten werden).

Dabei wird im Diagramm ein Beispiel zur Bordnetzinnenwiderstandsmessung mit folgenden Werten dargestellt: VER(t0) < 25 V gemessen. Gemäß dem beispielhaft verwendeten Design wird ein Strom I_up_dn = 22,5 mA für 100 mA Airbag-Versorgungsstrom aus VAS = 6,7 V und η_dn = 0,9 am VUP Eingang des VAS Abwärtwandlers benötigt. Die externen Sensoren sind noch nicht aktiv. Zusätzlich wird zum Laden der ER hier 60mA aus VUP entnommen. Die gesamte Strombelastung an VUP beträgt daher IVUP(to)=60mA+22.5mA=82.5mA. Um diesen Strom an VUP aufzubringen, sind an UBAT(t0)=12V, IBAT(t0) = 33V*82,5mA/(0,9*(12V - 0,5V)) = 263mA Batteriestrom notwendig.

IER(t1) = ER-Ladestrom wird von 60mA auf 0 mA geschaltet. VUP(t2)= 33V und UBAT(t3) = 12,2 V werden gemessen.

Der Strom an VUP deckt nur noch den Airbag Versorgungsstrom an VAS IVUP(t3) = I_up_dn= 22.5mA, dafür sind auf der Batterieseite

IBAT(t3)= 33V*22,5mA/(0,9*(12,2V - 0,5V)) = 71 mA notwendig (Messung nicht notwendig, nur ein fester Offsetwert). Es gelten ferner η_up=0,9 gemäß Design und Ud = 0,5V aus der Schottky-Verposchlutzdiode. IER(t4) = ER_Ladestrom wird von 0mA auf 120mA als zweiten Ladestromwert geschaltet. IER(t5)=120mA -Teststrom für Bordnetz-Innenwiderstand R. UBAT(T5) = 11,8 V wird dann (beispielsweise an der Primärschnittstelle über die Tiefpass-Schaltung 135 gemessen.

$$IBAT(t5) = 33V*142,5mA/(0,9*11,8V-0,5V)) = 463mA$$

$$\approx IBAT(t3)+33V*120mA/(0.9*11.8V-0.5V)$$

Mit UBAT(t3)-UBAT(t5) = 0,4V bestimmt aus Messung und IBAT(t3)-IBAT(t5) = 0,4A bestimmt aus der Änderung des ER Ladestromes (120mA) und einer Tabelle oder einer Strommessung mit Shunt in der UBAT Leitung, lässt sich hieraus der Bordnetz-Innenwiderstand R $\approx$ 1Ω bestimmen.

IER(t6) = ER-Ladestrom wird auf 0 mA geschaltet, ER wird dann nicht geladen. Als Plausibilisierung kann dann überprüft werden, ob UBAT (t3) = UBAT (t7) gilt.

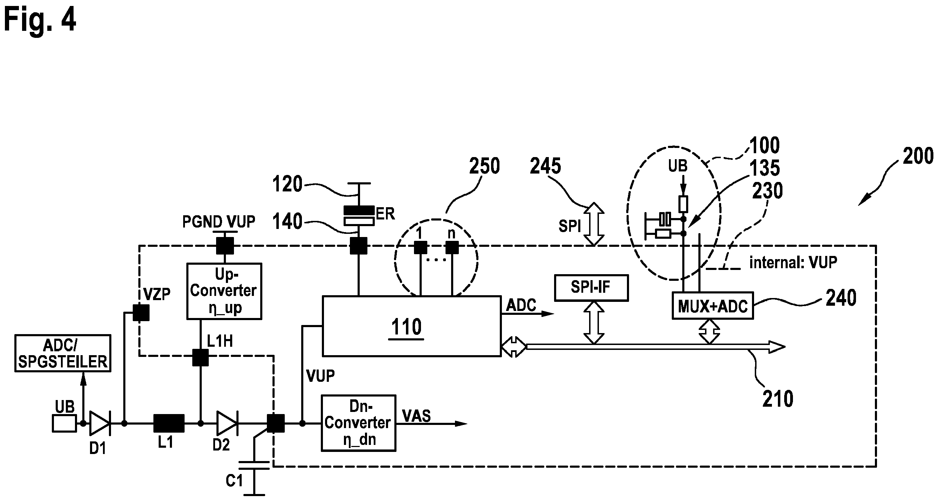

Fig. 4 zeigt einen Schaltplan einer Energieversorgungsschaltung 200 zur Verwendung in einem weiteren Ausführungsbeispiel der vorliegenden Erfindung. Dem Aufwärtswandler (Up-Converter) ist ein Abwärtswandler Dn-Converter mit Ausgangsanschluss VAS zur Steuergeräteversorgung (externe Sensorik + interne Vorversorgung) nachgeschaltet.

Dem Aufwärtswandler ebenfalls nachgeschaltet ist eine Ladeeinheit für die Energiereserve ER. Diese Ladeeinheit 110 kann entweder über parallele Steuerleitungen 250 oder über eine serielle Schnittstelle 245 gesteuert werden.

In den Figuren 2 und 4 ist in einem Airbag-Steuergerät der Bereich besonders markiert, der durch geeignete Anpassung auch die Forderung nach Bordnetzinnenwiderstandsüberwachung abdecken kann. Die Änderungen konzentrieren sich auf den ER-Lade-Strom-Regler 110 und die Batteriespannungserfassung an der Primärschnittstelle 135. Der Lade-Strom-Regler 110 sollte programmierbar oder steuerbar ausgeführt werden und ein neues Regelstromniveau erhalten, welches fähig ist auf der Primär (UBAT) -Seite eine zur Innenwiderstandsmessung R ausreichende Stromänderung zu verursachen.

Des Weiteren ist eine geeignete UBAT-Spannungsüberwachung mit Tiefpassfilter 220 an einem ADC vorzusehen (Primärschnittstelle 135), um die durch die Versorgungsstromänderung aufgrund des Bordnetz-Innenwiderstandes R gegebene Versorgungsspannungsänderung zu Erfassen (620).

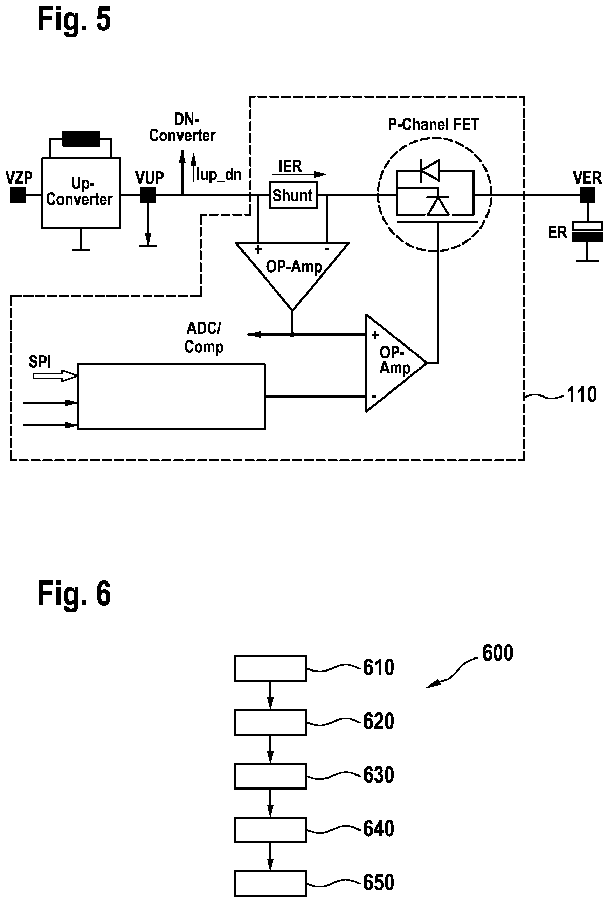

In Fig. 5 ist ein genauerer Schaltplan einer geeigneten ER-Ladestromquelle bzw. einer Energieversorgungsschaltung 200 angegeben. Über ein serielles Interface (z. B. SPI) oder ein paralleles Interface ist der Airbag-System-Controller in der Lage verschiedene Regelstromniveaus vorzugeben. Diese dienen dem Laden der Energiereserve ER.

Für ein Standard-Airbag-System genügt ein Stromniveau, wozu üblicherweise der Regler 110 nur über Steuerleitungen ein oder ausgeschaltet wird. Zur Innenwiderstandsmessung R sind deutlich höhere Lade-Regel-Stromwerte vorzugeben. Diese lassen sich in der Regel nicht zur vollständigen Ladung der ER nutzen (Stromaufnahme, Powerdissipation zu hoch).

Durch mehr Steuerleitungen oder der vollen Programmierbarkeit wird zur Innenwiderstandsmessung R des Bordnetzes 100 der ER-Lade-Regelstrom zeitlich begrenzt auf hohe Werte gesetzt. Dies geschieht gemäß der Darstellung aus Fig. 5 durch Änderung der Regler-Referenz-Spannung. Höhere Referenzspannungen führen zu höheren Regelströmen an der Sekundärschnittstelle 140.

Gemäß einem alternativen Lösungsansatz kann die aufwendige Mathematik (Teilen, Multiplieren) in dem vorstehend beschriebenen Ansatz bei der Prüfung des Innenwiderstandes R ohne merkliche Verschlechterung in eine (Nachschlage-) Tabelle überführt werden.

Dadurch ändert sich die Vorgehensweisebei der Prüfung wie folgt:
UBAT(t5)<6V-7 =[UBAT(t3)- UBAT(t5)]= δUBAT<= 1107mV; η_up =0.65 6.0<UBAT(t5)<=6.5V→ =[UBAT(t3)- UBAT(t5)] = δUBAT<= 942mV; η_up = 0.7 6.5<UBAT(t5)<=7.0V→ =[UBAT(t3)- UBAT(t5)]= δUBAT<= 812mV; η_up = 0.75 7.0<UBAT(t5)<=7.5V→ =[UBAT(t3)- UBAT(t5)]= δUBAT<= 707mV; η_up = 0.8 7.5<UBAT(t5)<=8.0V→ =[UBAT(t3)- UBAT(t5)]= δUBAT<= 640mV; η_up = 0.825 8.0<UBAT(t5)<=8.5V→ =[UBAT(t3)- UBAT(t5)]= δUBAT<= 600mV; η_up = 0.825 8.5<UBAT(t5)<=9.0V→ =[UBAT(t3)- UBAT(t5)]= δUBAT<= 548mV; η_up = 0.85 9.0<UBAT(t5)<=9.5V→=[UBAT(t3)- UBAT(t5)]= δUBAT<= 517mV; η_up = 0.85 UBAT(10.0V<=[UBAT(t3)→ UBAT(t5)] = δUBAT<= 476mV; n_up = 0.875 10<UBAT(t5)<=11V =[UBAT(t3)- UBAT(t5)]= δUBAT<= 452mV; η_up = 0.875 11<UBAT(t5)<=12V →=[UBAT(t3)- UBAT(t5)]= δUBAT<= 400mV; η_up =0.9 12<UBAT(t5)<=13V → =[UBAT(t3)- UBAT(t5)]= δUBAT<= 366mV; η_up =0.9 13<UBAT(t5)<=14V → =[UBAT(t3)- UBAT(t5)]= δUBAT<= 333mV; η_up =0.9125 14<UBAT(t5)<=15V → =[UBAT(t3)- UBAT(t5)]= δUBAT<= 309mV; η_up =0.9125 15<UBAT(t5)<=16V → =[UBAT(t3)- UBAT(t5)]= δUBAT<= 285mV; η_up =0.925 16<UBAT(t5)<=18V → =[UBAT(t3)- UBAT(t5)]= δUBAT<= 267mV; η_up =0.925 18<UBAT(t5) → =[UBAT(t3)- UBAT(t5)]= δUBAT<= 237mV; η_up =0.925

Die Prüfung in Programmschritt18) besteht dann nur noch aus der Prüfung von δUBAT, ist diese kleiner als ein Tabellenwert festgelegt durch UBAT(t5)wird Prüfung fortgesetzt in 20)
sonst in 19)

Ein weiteres Ausführungsbeispiel der Erfindung ist in der der nachfolgenden Beschreibung zu entnehmen. Die Tabelle lässt sich ohne merkliche Einbußen an Qualität in Fehlererkennung verkleinern:
UBAT(t5)<6V → =[UBAT(t3)- UBAT(t5)]= UBAT<= 1107mV; η_up =0.65 6.0<UBAT(t5)<=6.5V → =[UBAT(t3)- UBAT(t5)] = δUBAT<= 942mV; η_up = 0.7 6.5<UBAT(t5)<=7.0V →=[UBAT(t3)- UBAT(t5)]= δUBAT<= 812mV; η_up = 0.75 7.0<UBAT(t5)<=8.0V → =[UBAT(t3)- UBAT(t5)]= δUBAT<= 707mV; η_up = 0.8 8.0<UBAT(t5)<=9.0V → =[UBAT(t3)- UBAT(t5)]= δUBAT<= 600mV; η_up =0.825 9.0<UBAT(t5)<=11V → =[UBAT(t3)- UBAT(t5)]= δUBAT<= 517mV; η_up = 0.85 11<UBAT(t5)<=14V → =[UBAT(t3)-UBAT(5)]= δUBAT<= 400mV; η_up =0.9 14<UBAT(t5)<=18V → =[UBAT(t3)- UBAT(t5)]= δUBAT<= 309mV; η_up =0.9125 18<UBAT(t5) → =[UBAT(t3)- UBAT(t5)]= δUBAT<= 237mV; η_up =0.925

Zur Ermittlung des Versorgungsinnenwiderstandes sollte eine Airbag-Steuergeräteversorgungsspannungsmessung bei einem Eingangsstrom I1{IBAT(t1)} und bei einem Eingangsstrom I2{IBAT(T2)} zeitlich nahe beieinanderliegend durchgeführt werden. Die Differenz der Eingangsströme I1, I2 sollte so groß gewählt sein, dass relevante Widerstände (0.5 ... 1.5) Ω auflösbar sind. Die Auflösungsgrenze sollte für Airbag-Systeme bei <= 100 mΩ liegen. Zum Schutz der Messung gegen Störspannungen, Lastwechsel im Bordnetz 100 etc. ist diese geeignet zu filtern. Hierzu gehören neben einem Tiefpassfilter 220 eine mehrfache (>=3) schnelle Wiederholung der Messung mit Kontrolle der Eingangsspannung vor und nach der Messung.

Außerdem ist eine Filterung des Fehlers über mehrere Startvorgänge geeignet, um zufällige Störungen oder Sondererscheinungen nach langen Fahrzeug-Stillstandszeiten auszuschließen.

Airbag-Steuergeräte, die über einen Aufwärtswandler zur Erzeugung einer geregelten Ausgangsspannung VUP (20 ...50)V z.B. 33V aus der verpolungsgeschützten Fahrzeugspannung VZP (5...20)V verfügen und daraus zum einen, über einen Abwärtswandler eine geregelte Ausgangsspannung VAS (6...8)V z. B. 6.7V bereitstellen, zur weiteren verlustarmen Generierung der nötigen Systemspannungen(5V; 3.3V; 1.2V...etc..) sowie externen Sensor Versorgung und zum anderen über einen EIN/AUS-schaltbaren Energiereserve-Ladestromregler zur Ladung der ER auf ca. VUP verfügen, bilden die bekannte Lösungsbasis.

Fig. 6 zeigt ein Ablaufdiagramm eines Ausführungsbeispiels eines Verfahren 600 eines Verfahren zum Ermitteln eines Innenwiderstandes eines Versorgungsnetzes zur Energieversorgung.

Das Verfahren umfasst einen Schritt des Einprägens 610 eines ersten Ladestromwertes an der Sekundärschnittstelle 140. Ferner umfasst das Verfahren einen Schritt des Erfassens 620 bzw. bestimmen eines Stromes und/oder einer Spannung an der Primärschnittstelle (UB Ankopplung an die Versorgungseinheit des Steuergerätes) während des Einprägens 610 eines ersten Sekundärladestromes an der Sekundärankopplung 140 zur Energiereserve (ER) durch eine geeignete Messschaltung 135. Auch umfasst das Verfahren 600 einen Schritt 630 des Einprägens eines zweiten vom ersten unterschiedlichen Sekundärladestromes an der Sekundärankopplung 140 zur Energiereserve (ER) und einen Schritt 640 des erneuten Erfassens bzw. bestimmen eines Stromes und/oder einer Spannung an der Primärschnittstelle (UB) durch eine geeignete Messschaltung.

Weiterhin einen Schritt des Bestimmens 650 des Innenwiderstandes R des Versorgungsnetzes 100 unter Verwendung des erfassten bzw. bestimmten Stromes und/oder der erfassten Spannung während des Schrittes des Einprägens 610 und unter Verwendung des erfassten bzw. bestimmten Stromes und/oder der Erfassten 620 Spannung während des Schrittes des Aufprägens 630. Oder durch Bestimmung der Stromänderung an der Primärschnittstelle durch eine Zuordnungstabelle auf Basis der festgelegten Stromdifferenz zwischen Sekundärladestromwert 2 und Sekundärladestromwert 1 der Wandlercharackteristik (Wirkungsgrad) und dem Auswahlkriterium gemessene Primärspannung.

Mit anderen Worten ausgedrückt ist in der Fig. 6 ein Ablaufdiagramm eines Ausführungsbeispiels eines Verfahren 600 eines Verfahren zum Ermitteln eines Innenwiderstandes eines Versorgungsnetzes zur Energieversorgung dargestellt. Die Personenschutzeinrichtung beinhaltet eine Ladeeinheit, die mittels einer Primärschnittstelle mit dem Versorgungsnetz und mittels einer Sekundärschnittstelle mit einem Energiezwischenspeicher zur Zwischenspeicherung von Energie für Aktivierungen von Personenschutzmitteln der Personenschutzeinrichtung und der Versorgung der Personenschutzeinrichtung nach Trennung von dem Versorgungsnetz verbunden ist. Das Verfahren 600 weist einen Schritt 610 des Einprägens eines ersten Ladestromwertes an der Sekundärschnittstelle auf. Ferner weist das Verfahren einen Schritt 620 des Erfassens eines ersten Stromes und/oder einer ersten Spannung an der Primärschnittstelle während des Einprägens 610 auf. Auch umfasst das Verfahren 600 einen Schritt 630 des Aufprägens eines von dem ersten Ladestromwert unterschiedlichen zweiten Ladestromwertes an der Sekundärschnittstelle. Weiterhin umfasst das Verfahren 600 einen Schritt 640 des Bestimmens eines zweiten Stromes und/oder einer zweiten Spannung an der Primärschnittstelle während des Aufprägens. Schließlich umfasst das Verfahren 600 einen Schritt 650 des Ermittelns des Innenwiderstandes des Versorgungsnetzes unter Verwendung des ersten Stromes und des zweiten Stromes und/oder der ersten Spannung und der zweiten Spannung.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (600) zum Ermitteln eines Innenwiderstandes (R) eines Versorgungsnetzes (100) zur Energieversorgung einer Personenschutzeinrichtung (130) eines Fahrzeugs (105), wobei die Personenschutzeinrichtung (130) eine Ladeeinheit (110) beinhaltet, die mittels einer Primärschnittstelle (135) mit dem Versorgungsnetz (100) und mittels einer Sekundärschnittstelle (140) mit einem Energiezwischenspeicher (ER, 120) zur Zwischenspeicherung von Energie für Aktivierungen von Personenschutzmitteln (130) der Personenschutzeinrichtung (130) und der Versorgung der Personenschutzeinrichtung (130) nach Trennung von dem Versorgungsnetz (100) verbunden ist, wobei das Verfahren (600) die folgenden Schritte aufweist:

   - Einprägen (610) eines ersten Ladestromwertes (IER(t1)) an der Sekundärschnittstelle (140);
   - Erfassen (620) eines ersten Stromes und/oder einer ersten Spannung an der Primärschnittstelle (135) während des Einprägens (610);
   - Aufprägen (630) eines von dem ersten Ladestromwert (IER(t1)) unterschiedlichen zweiten Ladestromwertes (IER(t5)) an der Sekundärschnittstelle (140);
   - Bestimmen (640) eines zweiten Stromes und/oder einer zweiten Spannung an der Primärschnittstelle (135) während des Aufprägens; und
   - Ermitteln (650) des Innenwiderstandes (R) des Versorgungsnetzes (100) unter Verwendung des ersten Stromes und des zweiten Stromes und/oder der ersten Spannung und der zweiten Spannung.

2. Verfahren (600) gemäß Anspruch 1, **dadurch gekennzeichnet, dass** im Schritt des Ermittelns (650) der Innenwiderstand (R) unter Verwendung eines Wirkungsgrades ($\eta$) der Ladeeinheit (110), dem ersten Ladestromwert (IER(t1)) und/oder dem zweiten Ladestromwert (IER(t5)) bestimmt wird.

3. Verfahren (600) gemäß einem der vorangegangenen Ansprüche, **dadurch gekennzeichnet, dass** im Schritt des Erfassens (620) und/oder im Schritt des Bestimmens (640) der erste und/oder zweite Strom und/oder die erste und/oder zweite Spannung an der Primärschnittstelle (135) tiefpassgefiltert werden.

4. Verfahren (600) gemäß einem der vorangegangenen Ansprüche, **dadurch gekennzeichnet, dass** im Schritt des Aufprägens (630) der Sekundärschnittstelle (140) ein zweiter Ladestromwert (IER(t5)) aufgeprägt wird, der größer als der erste Ladestromwert (IER(t1)) ist, insbesondere wobei der zweite Ladestromwert (IER(t5)) im Vergleich zum ersten Ladestromwert (IER(t1)) derart gewählt ist, dass in Abhängigkeit von einem Wirkungsgrad ($\eta$) der Ladeeinheit (110) aus der ersten und/oder zweiten Spannung und/oder des ersten und/oder zweiten Stroms an der Primärschnittstelle (135) im Schritt des Ermittelns (650) ein Innenwiderstand (R) bestimmbar ist, der kleiner als ein vorbestimmter Innenwiderstand (R) des Versorgungsnetzes (100) ist.

5. Verfahren (600) gemäß einem der vorangegangenen Ansprüche, **dadurch gekennzeichnet, dass** im Schritt des Aufprägens (630) der Sekundärschnittstelle (140) der zweite Ladestromwert (IER(t5)) innerhalb einer vorbestimmten Zeitspanne nach Einprägen des ersten Ladestromwertes (IER(t1)) aufgeprägt wird.

6. Verfahren (600) gemäß einem der vorangegangenen Ansprüche, **dadurch gekennzeichnet, dass** im Schritt des Ermittelns (650) der Innenwiderstand (R) unter Verwendung einer Nachschlagetabelle bestimmt wird und/oder wobei in einem Schritt des Erfassens (620) und/oder des Bestimmens (640) die erste und/oder zweite Spannung und/oder der erste und/oder zweite Strom an der Primärschnittstelle (135) unter Verwendung einer Nachschlagetabelle bestimmt werden.

7. Verfahren (600) gemäß einem der vorangegangenen Ansprüche, **dadurch gekennzeichnet, dass** die Schritte des Einprägens (610), des Erfassens (620), des Aufprägens (630) und des Bestimmens (640) mehrfach zeitlich nacheinander ausgeführt werden, wobei im Schritt des Ermittelns (650) der Innenwiderstand (R) in Abhängigkeit von den in den Schritten des Einprägens (610) erfassten ersten Strömen und/oder den in den Schritten des Einprägens (610) erfassten ersten Spannungen und unter Verwendung der in den Schritten des Bestimmens (640) erfassten zweiten Strömen und/oder den zweiten Spannungen bestimmt wird.

8. Verfahren zur Ausgabe einer Fehlermeldung zur Information über eine Fehlfunktion eines Versorgungsnetzes (100) zur Energieversorgung einer Personenschutzeinrichtung (130) eines Fahrzeugs (105), wobei das Verfahren die folgenden Schritte aufweist:

   - die Schritte eines Verfahrens gemäß einem der vorangegangenen Ansprüche; und
   - Bereitstellen der Fehlermeldung, wenn der Innenwiderstand in einer vorbestimmten Beziehung zu einer Widerstandsschwelle steht.

9. Vorrichtung (200) zum Ermitteln eines Innenwiderstandes (R) eines Versorgungsnetzes (100) zur Energieversorgung einer Personenschutzeinrichtung (130) eines Fahrzeugs (105), wobei die Personenschutzeinrichtung (130) eine Ladeeinheit (110) beinhaltet, die mittels einer Primärschnittstelle (135) mit dem Versorgungsnetz (100) und mittels einer Sekundärschnittstelle (140) mit einem Energiezwischenspeicher (ER, 120) zur Zwischenspeicherung von Energie für Aktivierungen von Personenschutzmitteln (130) der Personenschutzeinrichtung (130) und der Versorgung der Personenschutzeinrichtung (130) nach Trennung von dem Versorgungsnetz (100) verbunden ist, wobei die Vorrichtung (200) die folgenden Merkmale aufweist:

   - eine Einheit (110, 140) zum Einprägen eines ersten Ladestromwertes (IER(t1)) an der Sekundärschnittstelle (140);
   - eine Einheit (MUX, ADC, 135) zum Erfassen eines ersten Stromes und/oder einer ersten Spannung an der Primärschnittstelle (135) während des Einprägens;
   - eine Einheit (110, 140) zum Aufprägen eines von dem ersten Ladestromwert (IER(t1)) unterschiedlichen zweiten Ladestromwertes (IER(t5)) an der Sekundärschnittstelle;
   - eine Einheit (MUX, ADC, 135) zum Bestimmen eines zweiten Stromes und/oder einer zweiten Spannung an der Primärschnittstelle (135) während des Aufprägens; und
   - eine Einheit (110) zum Ermitteln des Innenwiderstandes (R) des Versorgungsnetzes (100) unter Verwendung des ersten Stromes und des zweiten Stromes und/oder der ersten Spannung und der zweiten Spannung.

10. Computer-Programmprodukt mit Programmcode zur Durchführung des Verfahrens (600) nach einem der Ansprüche 1 bis 8, wenn das Programmprodukt auf einer Vorrichtung (200) ausgeführt wird.

**EP 3 132 271 B1**

**Claims**

1. Method (600) for identifying an internal resistance (R) of a power supply network (100) for supplying energy to a personal protection device (130) of a vehicle (105), wherein the personal protection device (130) contains a charging unit (110), which is connected by means of a primary interface (135) to the power supply network (100) and by means of a secondary interface (140) to an energy buffer store (ER, 120) for the buffer storage of energy for activations of personal protection means (130) of the personal protection device (130) and for the supply of power to the personal protection device (130) after isolation from the power supply network (100), wherein the method (600) has the following steps:

   - impressing (610) a first charging current value (IER(t1)) at the secondary interface (140);
   - detecting (620) a first current and/or a first voltage at the primary interface (135) during the impressing (610);
   - impressing (630) a second charging current value (IER(t5)), which is different from the first charging current value (IER(t1)), at the secondary interface (140);
   - determining (640) a second current and/or a second voltage at the primary interface (135) during the impressing; and
   - identifying (650) the internal resistance (R) of the power supply network (100) using the first current and the second current and/or the first voltage and the second voltage.

2. Method (600) according to Claim 1, **characterized in that**, in the identification step (650), the internal resistance (R) is determined using an efficiency ($\eta$) of the charging unit (110), the first charging current value (IER(t1)) and/or the second charging current value (IER(t5)).

3. Method (600) according to either of the preceding claims, **characterized in that**, in the detection step (620) and/or in the determination step (640), the first and/or second current and/or the first and/or second voltage at the primary interface (135) are subjected to low-pass filtering.

4. Method (600) according to one of the preceding claims, **characterized in that**, in the step of impressing (630) the secondary interface (140), a second charging current value (IER(t5)) greater than the first charging current value (IER(t1)) is impressed, in particular wherein the second charging current value (IER(t5)) is selected compared to the first charging current value (IER(t1)) in such a way that, in the identification step (650), an internal resistance (R) can be determined from the first and/or second voltage and/or the first and/or second current at the primary interface (135) depending on an efficiency ($\eta$) of the charging unit (110), said internal resistance being lower than a predetermined internal resistance (R) of the power supply network (100).

5. Method (600) according to one of the preceding claims, **characterized in that**, in the step of impressing (630) the secondary interface (140), the second charging current value (IER(t5)) is impressed within a predetermined time period after the impressing of the first charging current value (IER(t1)).

6. Method (600) according to one of the preceding claims, **characterized in that**, in the identification step (650), the internal resistance (R) is determined using a look-up table and/or wherein, in a detection step (620) and/or determination step (640), the first and/or second voltage and/or the first and/or second current at the primary interface (135) are determined using a look-up table.

7. Method (600) according to one of the preceding claims, **characterized in that** the steps of impressing (610), detecting (620), impressing (630) and determining (640) are executed several times in temporal succession, wherein, in the identification step (650), the internal resistance (R) is determined depending on the first currents detected in the impressing steps (610) and/or the first voltages detected in the impressing steps (610) and using the second currents and/or the second voltages detected in the determining steps (640).

8. Method for outputting a fault message for information about a malfunction of a power supply network (100) for supplying energy to a personal protection device (130) of a vehicle (105), wherein the method has the following steps:

   - the steps of a method according to one of the preceding claims; and
   - providing the fault message when the internal resistance is in a predetermined relationship with a resistance threshold.

9. Apparatus (200) for identifying an internal resistance (R) of a power supply network (100) for supplying energy to

15

a personal protection device (130) of a vehicle (105), wherein the personal protection device (130) contains a charging unit (110), which is connected by means of a primary interface (135) to the power supply network (100) and by means of a secondary interface (140) to an energy buffer store (ER, 120) for the buffer storage of energy for activations of personal protection means (130) of the personal protection device (130) and the supply of power to the personal protection device (130) after isolation from the power supply network (100), wherein the apparatus (200) has the following features:

- a unit (110, 140) for impressing a first charging current value (IER(t1)) at the secondary interface (140);
- a unit (MUX, ADC, 135) for detecting a first current and/or a first voltage at the primary interface (135) during the impressing;
- a unit (110, 140) for impressing a second charging current value (IER(t5)), which is different from the first charging current value (IER(t1)), at the secondary interface (140);
- a unit (MUX, ADC, 135) for determining a second current and/or a second voltage at the primary interface (135) during the impressing; and
- a unit (110) for identifying the internal resistance (R) of the power supply network (100) using the first current and the second current and/or the first voltage and the second voltage.

**10.** Computer program product having program code for carrying out the method (600) according to one of Claims 1 to 8 when the program product is executed on an apparatus (200).

## Revendications

**1.** Procédé (600) de détermination de la résistance interne (R) d'un réseau d'alimentation (100) qui alimente en énergie un dispositif (130) de protection des personnes dans un véhicule (105),
le dispositif (130) de protection des personnes contenant une unité de charge (110) qui est raccordée au moyen d'une interface primaire (135) au réseau d'alimentation (100) et au moyen d'une interface secondaire (140) à une réserve intermédiaire d'énergie (ER, 120) qui conserve temporairement l'énergie d'activation de moyens (130) de protection des personnes du dispositif (130) de protection des personnes et qui alimente le dispositif (130) de protection des personnes après séparation du réseau d'alimentation (100), le procédé (600) comportant les étapes suivantes :

application (610) d'une première valeur (IER(t1)) de courant de charge sur l'interface secondaire (140),
saisie (620) d'un premier courant et/ou d'une première tension sur l'interface primaire (135) pendant l'application (610),
application (630) d'une deuxième valeur (IER(t5)) de courant de charge, différente de la première valeur (IER(t1)) de courant de charge, sur l'interface secondaire (140),
détermination (640) d'un deuxième courant et/ou d'une deuxième tension sur l'interface primaire (135) pendant l'application et
détermination (650) de la résistance interne (R) du réseau d'alimentation (100) en recourant au premier courant et au deuxième courant et/ou à la première tension et à la deuxième tension.

**2.** Procédé (600) selon la revendication 1, **caractérisé en ce qu'**à l'étape de détermination (650), la résistance interne (R) est déterminée en recourant à un taux d'efficacité (η) de l'unité de charge (110), à la première valeur (IER(t1)) du courant de charge et/ou à la deuxième valeur (IER(t5)) du courant de charge.

**3.** Procédé (600) selon l'une des revendications précédentes, **caractérisé en ce qu'**à l'étape de saisie (620) et/ou à l'étape de détermination (640), le premier et/ou le deuxième courant et/ou la première et/ou la deuxième tension pour l'interface primaire (135) subissent un filtrage passe-bas.

**4.** Procédé (600) selon l'une des revendications précédentes, **caractérisé en ce qu'**à l'étape d'application (630), la deuxième valeur (IER(t5)) du courant de charge appliquée sur l'interface secondaire (140) est supérieure à la première valeur (IER(t1)) du courant de charge, et en particulier la deuxième valeur (IER(t5)) du courant de charge est sélectionnée par rapport à la première valeur (IER(t1)) du courant de charge de telle sorte qu'en fonction du degré d'efficacité (η) de l'unité de charge (110), une résistance interne (R) plus petite qu'une résistance interne (R) prédéterminée du réseau d'alimentation (100) peut être déterminée à partir de la première et/ou de la deuxième tension et/ou du premier et/ou du deuxième courant sur l'interface primaire (135).

**5.** Procédé (600) selon l'une des revendications précédentes, **caractérisé en ce qu'**à l'étape d'application (630), la deuxième valeur (IER(t5)) du courant de charge est appliquée sur l'interface secondaire (140) pendant un intervalle de temps prédéterminé qui suit l'application de la première valeur (IER(t1)) du courant de charge.

**6.** Procédé (600) selon l'une des revendications précédentes, **caractérisé en ce qu'**à l'étape de détermination (650), la résistance interne (R) est déterminée en recourant à un tableau de référence et/ou **en ce que** dans une étape de saisie (620) et/ou de détermination (640), la première et/ou la deuxième tension et/ou le premier et/ou le deuxième courant et/ou l'interface primaire (135) sont définis en recourant à un tableau de référence.

**7.** Procédé (600) selon l'une des revendications précédentes, **caractérisé en ce que** l'étape d'application (610), de saisie (620), d'application (630) et de détermination (640) sont exécutées plusieurs fois successives, et **en ce qu'**à l'étape de la détermination (650), la résistance interne (R) est déterminée en fonction des premiers courants saisis aux étapes d'application (610) et/ou des premières tensions saisies aux étapes d'application (610) et en recourant aux deuxièmes courants et/ou aux deuxièmes tensions saisis aux étapes de détermination (640).

**8.** Procédé d'émission d'un message d'erreur informant sur un fonctionnement défectueux d'un réseau d'alimentation (100) qui alimente en énergie un dispositif (130) de protection des personnes d'un véhicule (105), le procédé comportant les étapes suivantes :

les étapes d'un procédé selon l'une des revendications précédentes et
l'envoi du message d'erreur si la résistance interne présente un rapport prédéterminé à un seuil de résistance.

**9.** Ensemble (200) de détermination de la résistance interne (R) d'un réseau d'alimentation (100) qui alimente en énergie un dispositif (130) de protection des personnes dans un véhicule (105),
le dispositif (130) de protection des personnes contenant une unité de charge (110) qui est raccordée au moyen d'une interface primaire (135) au réseau d'alimentation (100) et au moyen d'une interface secondaire (140) à une réserve intermédiaire d'énergie (ER, 120) qui conserve temporairement l'énergie d'activation de moyens (130) de protection des personnes du dispositif (130) de protection des personnes et qui alimente le dispositif (130) de protection des personnes après séparation du réseau d'alimentation (100), le dispositif (200) présentant les caractéristiques suivantes :

une unité (110, 140) qui applique une première valeur (IER(t1)) du courant de charge sur l'interface secondaire (140),
une unité (MUX, ADC, 135) qui saisit un premier courant et/ou une première tension sur l'interface primaire (135) pendant l'application,
une unité (110, 140) d'application d'une deuxième valeur (IER(t5)) de courant de charge, différente de la première valeur (IER(t1)) de courant de charge, sur l'interface secondaire (140),
une unité (MUX, ADC, 135) qui détermine un deuxième courant et/ou une deuxième tension sur l'interface primaire (135) pendant l'application et
une unité (110) qui détermine la résistance interne (R) du réseau d'alimentation (100) en recourant au premier courant et au deuxième courant et/ou à la première tension et à la deuxième tension.

**10.** Produit de programme informatique doté de codes de programme permettant de mettre en oeuvre le procédé (600) selon l'une des revendications 1 à 8 lorsque le produit de programme est exécuté sur un ensemble (200).

Fig. 1

Fig. 2

EP 3 132 271 B1

Fig. 3

EP 3 132 271 B1

# Fig. 4

# Fig. 5

# Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2005231218 A1
- US 6114838 A
- CN 101477149 A